# FASCICULE DE BREVET EUROPEEN

(11) **EP 0 603 026 B1**
(45) Date de publication et mention de la délivrance du brevet: **28.08.1996**
(21) Numéro de dépôt: 93402926.5
(22) Date de dépôt: 02.12.1993
(51) Int. Cl.: H02H 9/04, H05K 9/00, H01R 13/66

(54) **Dispositif pour la protection d'une installation électronique contre des perturbations engendrées par des phénomènes affectant le milieu extérieur dans lequel se trouve placée l'installation**
Vorrichtung zum Schutz einer elektronischen Einrichtung gegen Störungen, verursacht durch Einflüsse der Umgebung in welcher sich die Einrichtung befindet
Protection device for electronic installations against transients generated by phenomena affecting the environment outside of the installation

(30) Priorité: 17.12.1992 FR 9215557
(43) Date de publication de la demande: 22.06.1994
(73) Titulaire: SEXTANT AVIONIQUE, F-92366 Meudon la Forêt Cédex (FR)
(72) Inventeur: de la Croix Vaubois, Christine, F-92300 Levallois (FR); Goy, Jean-Marie, F-91700 Saint Genevieve des Bois (FR); Nemoz, Gérard, F-94700 Maisons Alfort (FR)
(74) Mandataire: de Saint-Palais, Arnaud Marie

(56) Documents cités:
- EP-A- 0 220 677
- GB-A- 2 209 893

## Description

La présente invention concerne un dispositif pour la protection d'une installation électronique contre des perturbations engendrées par des phénomènes affectant le milieu extérieur dans lequel se trouve placée l'installation.

Elle s'applique plus particulièrement, mais non exclusivement, à la protection contre la foudre, voire même les interférences électromagnétiques IEM, des installations électroniques situées à bord d'un aérodyne.

On sait qu'à l'heure actuelle, ces installations présentent de plus en plus souvent des structures modulaires faisant intervenir des baies à l'intérieur desquelles peuvent venir s'engager, à la façon de tiroirs, des éléments fonctionnels modulaires.

Les connexions de ces éléments modulaires, entre eux et avec l'extérieur (liaisons aérodyne) s'effectuent grâce à un circuit d'interconnexion prévu dans le fond de la baie.

Bien entendu, ce circuit d'interconnexion comprend des éléments de connexion aptes à coopérer avec des moyens de connexion correspondants, intégrés à chacun des éléments modulaires.

Jusqu'ici, la protection de ces installations contre la foudre ou les interférences électromagnétiques était assurée (à la demande de l'utilisateur) grâce à des circuits de protection intégrés aux circuits électroniques des éléments modulaires.

Il s'avère que cette solution présente de nombreux inconvénients.

Elle exige tout d'abord une conception spécifique des cartes de circuits électroniques des éléments modulaires, lesquels seront différents selon qu'on effectue ou non la susdite protection.

La protection d'un élément modulaire non protégé à l'origine implique donc un changement de carte de circuit imprimé, c'est-à-dire une intervention coûteuse qui n'est réalisable que par un spécialiste.

Par ailleurs, compte tenu de leur intégration dans les circuits électroniques des éléments modulaires, les circuits de protection traitent les perturbations au sein même des circuits qu'ils sont censés protéger, de sorte que, paradoxalement, ces derniers se trouvent d'autant mieux exposés à ces perturbations.

Un autre inconvénient de cette intégration consiste en ce que les circuits de protection peuvent être difficilement testés.

Il s'avère en outre que cette solution est mal adaptée pour résoudre les problèmes de dissipation thermique qui se posent notamment lorsqu'à la suite d'un coup de foudre, la surintensité qui traverse le circuit de protection provoque, à l'intérieur de l'élément modulaire, une élévation brutale et intense de température.

L'invention a donc plus particulièrement pour but de supprimer ces inconvénients.

Elle propose à cet effet un dispositif de protection faisant intervenir :
- d'une part, un premier élément de connecteur monté sur la baie et dont les organes de connexion sont électriquement reliés à des conducteurs respectifs du circuit d'interconnexion susceptibles de constituer des vecteurs de propagation des susdites perturbations, et
- d'autre part, un module de protection comprenant un boîtier logeant des circuits de protection respectivement associés auxdits conducteurs et électriquement reliés à des organes de connexion d'un deuxième élément de connecteur apte à venir se connecter sur le premier élément de connecteur afin d'assurer une liaison électrique déconnectable entre lesdits conducteurs et les circuits de protection correspondants.

Il apparaît clairement que, grâce à une telle solution :
. La protection des éléments modulaires de l'installation électronique s'effectue à l'extérieur de ces éléments, voire même de la baie, de sorte que les perturbations sont neutralisées avant même d'atteindre (directement ou indirectement) les circuits électroniques à protéger.
. Les éléments de protection n'ont aucune incidence sur la structure et la conception des circuits électroniques des éléments modulaires. Ceux-ci demeurent identiques, en présence ou en l'absence de protection. Il en résulte donc, grâce à cette interchangeabilité, une plus grande adaptabilité et une plus grande disponibilité des éléments modulaires.
. Les circuits de protection sont confinés à l'intérieur d'un boîtier extérieur situé à un emplacement où il n'y a aucun risque de perturbation des circuits électroniques, ce boîtier, de même que les structures de support des circuits de protection, étant conçus de manière à assurer les meilleures conditions de fonctionnement et, en particulier, les meilleurs transferts thermiques possibles.

Un mode d'exécution de l'invention sera décrit ci-après, à titre d'exemple non limitatif, avec référence aux dessins annexés dans lesquels :
La figure 1 est une représentation schématique montrant en perspective, vue d'arrière, une baie destinée à recevoir des éléments modulaires ;
La figure 2 est une coupe schématique illustrant le principe de la connexion d'un module de connexion sur un connecteur fixé sur le fond de la baie ;
La figure 3 montre la structure intérieure d'un module de protection ;
La figure 4 est une représentation schématique d'une matrice de passage formée sur le circuit d'interconnexion prévu dans le fond de la baie.

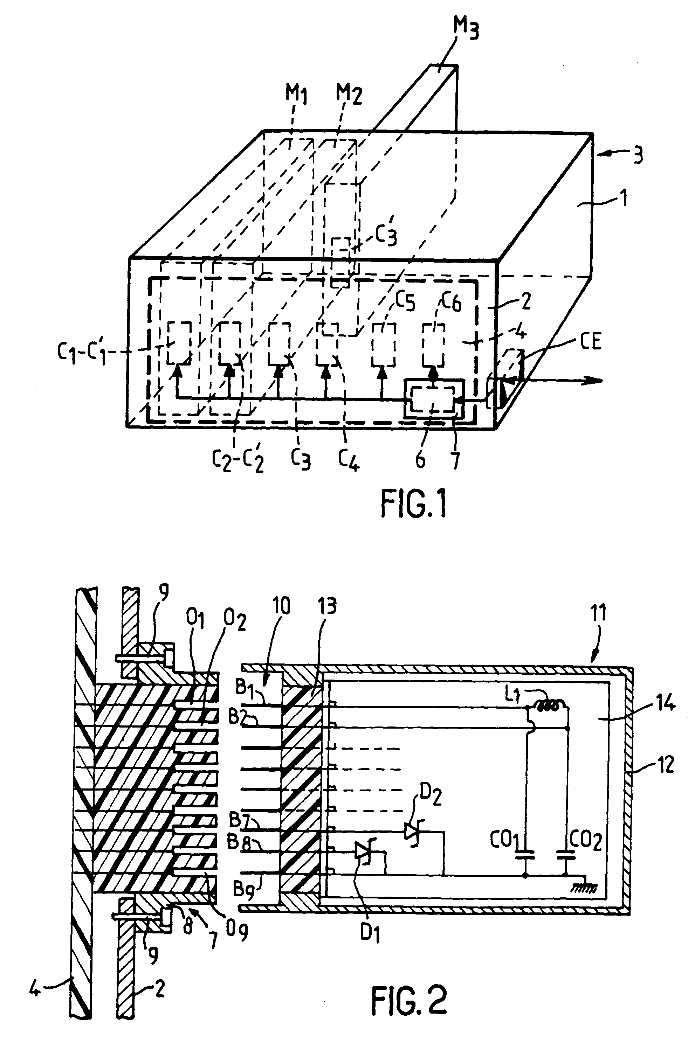

Dans l'exemple représenté sur la figure 1, la baie 1, de forme parallélépipédique, présente un fond 2 et, du côté opposé à ce fond, une face antérieure ouverte 3 par laquelle sont engagés à la façon de tiroirs, des modules électroniques M₁, M₂, M₃ pouvant, par exemple, consister en des éléments de calculateur.

A l'intérieur de la baie 1 est disposée, parallèlement au fond et à faible distance de celui-ci, une carte de circuit imprimé 4 servant à l'interconnexion des modules M₁, M₂, M₃ entre eux et avec les circuits extérieurs auxquels est raccordée la baie.

Les connexions entre cette carte de circuit imprimé 4 et les modules électroniques M₁, M₂, M₃ sont assurées par des connecteurs enfichables C₁-C'₁, C₂-C'₂, C₃-C'₃, C₄, C₅, C₆ respectivement prévus sur ladite carte 4 et sur les faces arrière desdits modules M₁, M₂, M₃.

Les liaisons entre la carte d'interconnexion 4 et les circuits extérieurs s'effectuent ici grâce à un connecteur CE prévu sur l'une des faces latérales de la baie 1.

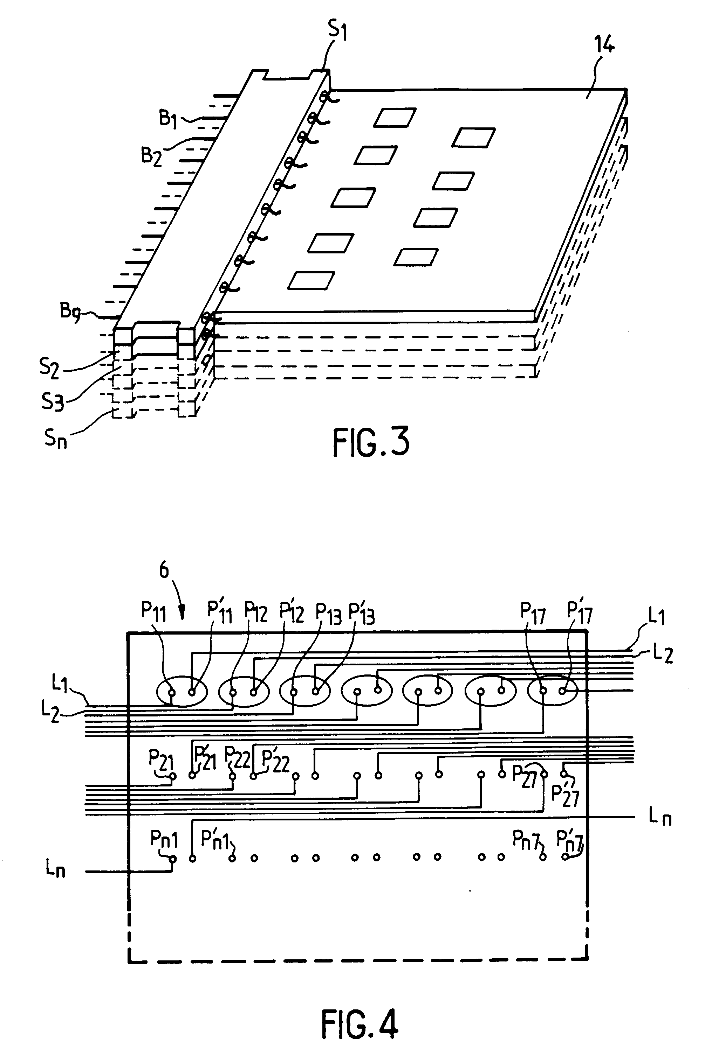

Conformément à l'invention, les circuits de la carte d'interconnexion 4, qui assurent les liaisons entre les connecteurs C₁ à C₆ associés aux éléments modulaires M₁ à M₃ et le connecteur CE, sont disposés de manière à réaliser une matrice de passage (bloc 6), par exemple du type de celle représentée figure 4, dont chacun des points P₁₁, P'₁₁ à Pₙ₇, P'ₙ₇ est relié à un organe de connexion d'un connecteur 7 monté sur le fond 2 de la baie 1, par exemple de la façon illustrée sur la figure 2.

Dans cet exemple, le connecteur 7 comprend une multiplicité d'organes de connexion O₁ à O₉, de type femelle montés dans un support isolant 8 et respectivement reliés à des points de la matrice de passage 6 de la carte d'interconnexion 4.

Ce connecteur 7, qui passe au travers d'un orifice pratiqué dans le fond 2 de la baie 1 et qui est fixé sur celle-ci au moyen de vis 9, est destiné à recevoir un connecteur de type mâle 10 solidaire d'un module de protection 11.

Ce module de protection 11, qui constitue un bloc standard interchangeable, se compose d'un boîtier 12 métallique ou métallisé de forme parallélépipédique dont la partie antérieure est constituée par le connecteur mâle 10, lequel comprend une multiplicité de broches conductrices B₁ à B₉ montées dans un support isolant 13 qui forme la paroi antérieure du boîtier 12.

Chacune de ces broches B₁ à B₉ est reliée à un circuit de protection porté par une plaquette de circuit imprimé 14 logée à l'intérieur du boîtier 12.

Dans l'exemple représenté sur la figure 2, on n'a représenté que trois circuits de protection de deux types différents, à savoir :
- deux circuits de protection anti-foudre faisant chacun intervenir une diode foudre D₁, D₂ reliant une broche B₇, B₈ à la masse (broche B₉),
- un circuit de protection contre les interférences électromagnétiques IEM comprenant une inductance L₁ dont chacune des bornes est reliée à une broche respective et à la masse, par l'intermédiaire d'un condensateur CO₁, CO₂, de manière à réaliser un filtre en π.

Bien entendu, chaque circuit de protection pourra comprendre, en combinaison, un circuit de protection contre les interférences électromagnétiques et un circuit de protection anti-foudre dont la diode foudre est connectée en amont de l'inductance.

Avantageusement, la plaquette 14, de type double face, comprend un substrat de type céramique ou FR4 présentant, sur un bord, deux barrettes de contacts sur lesquelles sont brasées les broches B₁ à B₉ et sont assemblées sous forme de "chip on board", les diodes foudre D₁, D₂ ainsi que les filtres L₁, CO₁, CO₂.

Bien entendu, la puissance et la tension des diodes D₁, D₂ (breakdown) peuvent être choisies parmi des valeurs pré-selectionnées. Eventuellement, ces diodes D₁, D₂ pourront être montées en série.

De même, la valeur de l'impédance L₁ et des condensateurs CO₁, CO₂ sera déterminée en fonction de la nature des perturbations que l'on souhaite filtrer.

Il s'avère que les circuits de protection anti-foudre n'exigent qu'une simple connexion sur un point P₁,1-P'₁,1-Pₙ,7-P'ₙ,7 de la matrice de passage 6 et ce, sans avoir à effectuer une interruption de la ligne L₁, L₂... Lₙ du circuit d'interconnexion passant par ce point.

De ce fait, lorsqu'il ne comprend que des circuits de protection anti-foudre, le module de protection 11 peut être ôté sans que sa déconnexion perturbe le fonctionnement de la baie 1.

Par contre, les circuits de protection contre les interférences électromagnétiques exigent le montage de l'inductance L₁, en série sur la ligne, et donc une interruption de cette ligne entre les deux points sur lesquels vient se connecter cette inductance L₁.

Il est clair que dans ce cas, la déconnexion du module de protection 11 ne peut s'effectuer sans causer une perturbation du fonctionnement de la baie 1, et doit être suivie d'une opération visant à rétablir la continuité des lignes L₁, L₂... Lₙ qui se trouvent alors interrompues du fait de cette déconnexion.

La figure 4 montre un exemple d'exécution d'une matrice de passage 6 appropriée à des modules de protection utilisant des circuits de protection qui nécessitent ou non l'interruption des lignes L₁, L₂... Lₙ à protéger.

Cette matrice de passage 6 présente une surface sensiblement identique à l'aire de connexion du connecteur 7, et est agencée de manière à être traversée par n lignes de la carte d'interconnexion 4 que l'on veut protéger.

Dans cette surface, chaque ligne L₁, L₂... Lₙ est interrompue entre un couple de points P₁₁-P'₁₁, P₁₂-P'₁₂... sur lesquels viennent respectivement se connecter deux organes de connexion O₁ à O₉ du connecteur 7.

Les différents couples de points P₁₁-P'₁₁, P₁₂-P'₁₂... sont agencés de manière à réaliser une matrice de points qui coïncide avec la matrice d'organes de connexion O₁, O₉ du connecteur 7.

Dans le cas où l'on désire assurer sur une ligne L₁... Lₙ uniquement une protection contre la foudre, les éléments de connexion B₁, B₉ du module de protection 11 qui correspondent au couple de points P₁₁-P'₁₁, P₁₂-P'₁₂ correspondant à cette ligne, sont reliés l'un à l'autre par une liaison conductrice (non représentée) ainsi qu'à un circuit de protection pouvant comprendre une diode foudre D₁, D₂ reliée à la masse.

Par contre, dans le cas où l'on désire protéger une ligne contre les interférences électromagnétiques, les éléments de protection du module de protection qui correspondent au couple de points P₁₁-P'₁₁, P₁₂-P'₁₂... correspondant à cette ligne sont reliés l'un à l'autre par une inductance L, et à la masse, par rapport à deux condensateurs CO₁, CO₂ respectifs.

Dans le cas où l'on ne souhaite pas protéger la baie 1, il est alors nécessaire d'utiliser, au lieu d'un module de protection, un module de connexion conçu de manière à assurer une connexion électrique entre chaque couple de points P₁₁-P'₁₁, P₁₂-P'₁₂...

Il apparaît donc que grâce à ces dispositions, l'utilisateur pourra à tout instant supprimer ou rétablir les protections anti-foudre et/ou contre les interférences électromagnétiques, sans avoir à modifier la baie et/ou ses éléments modulaires : un simple changement du module de protection 11 par un autre module de protection, voire même par un module de connexion suffit.

Un autre avantage de cette solution consiste en ce que les circuits de protection des modules de protection peuvent être facilement testés sans avoir à intervenir sur la baie ou sur les éléments modulaires qu'elle renferme.

Avantageusement, la conception des circuits de protection pourra être fonction de la structure de la matrice de passage et des connecteurs qui lui sont associés.

Ainsi, les broches du connecteur intégré au module de protection pourront présenter une disposition matricielle similaire à celle de la matrice de passage.

Dans ce cas, chaque ligne de broches B₁ à B₉ est montée dans un support isolant respectif S₁, S₂... Sₙ conçu de manière à pouvoir s'empiler sur le support isolant affecté à une ligne adjacente (figure 3).

Par ailleurs, les broches B₁ à B₉ d'une même ligne de broches sont connectées à des circuits portés par une même face d'une plaquette de circuit imprimé 14 (les circuits présents sur les deux faces de la plaquette étant respectivement connectés aux broches portées par deux supports successifs S₁... Sₙ).

Grâce à une telle disposition, il est possible d'adapter facilement le module de protection à la taille du connecteur de protection présent sur la baie.

On augmente ainsi la flexibilité et l'adaptabilité du dispositif de protection.

Sa fiabilité et son efficacité peuvent être facilement accrues grâce au fait que l'on peut utiliser pour la réalisation des modules de protection, les matériaux les plus appropriés notamment pour résister à des températures élevées et pour assurer les transferts thermiques nécessaires, notamment vers l'extérieur et ce, sans risque d'endommager les composants de la baie et/ou des modules électroniques qu'elle contient.

## Revendications

1. Dispositif pour la protection d'une installation électronique contre des perturbations engendrées par des phénomènes affectant le milieu extérieur dans lequel elle se trouve placée, cette installation comportant une baie (1) dans laquelle peuvent venir s'engager des éléments fonctionnels modulaires (M₁, M₂, M₃), interconnectés entre eux et avec des circuits extérieurs grâce à un circuit d'interconnexion (4) prévu dans le fond de la baie,
caractérisé en ce qu'il fait intervenir :
- d'une part, un premier élément de connecteur (7) monté sur la baie (1) et dont les organes de connexion (O₁ à O₉) sont électriquement reliés à des conducteurs respectifs (L₁, L₂... Lₙ) du circuit d'interconnexion (4) susceptibles de constituer des vecteurs de propagation des susdites perturbations, et
- d'autre part, un module de protection (11) comprenant un boîtier (12) logeant des circuits de protection respectivement associés auxdits conducteurs (L₁, L₂... Lₙ) et électriquement reliés à des organes de connexion (B₁ à B₉) d'un deuxième élément de connecteur (10) apte à venir se connecter sur le premier élément de connecteur (7) afin d'assurer une liaison électrique déconnectable entre lesdits conducteurs (L₁, L₂... Lₙ) et les circuits de protection correspondants.

2. Dispositif selon la revendication 1,
caractérisé en ce que les lignes (L₁ à Lₙ) du circuit d'interconnexion qui assurent les liaisons entre les éléments modulaires (M₁, M₂, M₃) et les circuits extérieurs sont disposées de manière à réaliser une matrice de passage (6) dont chacun des points (P₁₁... Pₙ₇, P'₁₁... P'ₙ₇) qui est en contact électrique avec une ligne (L₁ à Lₙ) correspondante est relié à un organe de connexion (O₁... O₉) dudit premier élément de connecteur (7).

3. Dispositif selon la revendication 2,
caractérisé en ce que les circuits de protection comprennent au moins une diode anti-foudre (D₁, D₂) reliée entre la masse et l'un, au moins, des points de la matrice de passage (6), par l'intermédiaire des deux éléments de connecteur (7, 10).

4. Dispositif selon la revendication 1,
caractérisé en ce qu'au moins une partie des lignes (L₁... Lₙ) du circuit d'interconnexion (4) qui assure les liaisons entre les éléments modulaires (M₁, M₂, M₃) et les circuits extérieurs est disposée de manière à réaliser une matrice de passage (6), et en ce que chacune desdites lignes (L₁... Lₙ) est interrompue entre deux points situés dans la matrice de passage (6) et reliés à deux organes de connexion dudit premier élément de connecteur (7).

5. Dispositif selon la revendication 4,
caractérisé en ce que le module de protection (11) comprend des moyens permettant d'assurer, grâce aux deux susdits éléments de connecteur (7, 10), une connexion électrique entre deux points d'une même ligne (L₁... Lₙ) avec une liaison éventuelle à la masse par l'intermédiaire d'un circuit de protection anti-foudre.

6. Dispositif selon la revendication 4,
caractérisé en ce que le module de protection comprend un circuit de protection venant se brancher entre les deux points (P₁₁, P'₁₁) d'une même ligne (L₁) grâce aux deux susdits éléments de connecteur (7, 10).

7. Dispositif selon la revendication 6,
caractérisé en ce que le circuit de protection comprend une impédance (L₁) connectée entre lesdits points (P₁₁, P'₁₁), et deux condensateurs (CO₁, CO₂) reliant chacun desdits points à la masse.

8. Dispositif selon l'une des revendications précédentes,
caractérisé en ce que le module de protection (11) comprend un boîtier (12) dont la partie antérieure est constituée par un élément de connecteur (10) comprenant au moins une ligne d'organes de connexion (B₁ à B₉) montés dans un support isolant (13), et en ce que les circuits de protection et/ou de connexion sont portés par au moins une plaquette de circuit imprimé (14) logée dans le boîtier (12) et électriquement reliée auxdits organes de connexion (B₁ à B₉).

9. Dispositif selon la revendication 8,
caractérisé en ce que l'élément de connecteur (10) du module de protection (11) comprend une pluralité de lignes d'organes de connexion (B₁ à B₉) respectivement montées sur une pluralité de supports isolants (S₁, Sₙ) empilés les uns sur les autres, et en ce que le boîtier (12) renferme une pluralité de plaquettes de circuit imprimé double face (14) dont chacune des faces est électriquement reliée à une ligne d'organes de connexion (B₁ à B₉) correspondante.

## Patentansprüche

1. Vorrichtung zum Schutz einer elektronischen Anlage vor Störungen, die von Phänomenen erzeugt werden, welche die Außenumgebung beeinflussen, in der sie sich befindet, wobei diese Anlage einen Rahmen (1) aufweist, in den modulare funktionelle Elemente (M₁, M₂, M₃) eingesetzt werden können, die miteinander und mit äußeren Schaltungen über eine Verbindungsschaltung (4) verbunden sind, die am Boden des Rahmens vorgesehen ist,
dadurch gekennzeichnet, daß sie verwendet:
- einerseits ein erstes Verbinderelement (7), das auf den Rahmen (1) montiert ist und dessen Verbindungsorgane (O₁ bis 0₉) elektrisch mit Leitern (L₁, L₂ ... Lₙ) der Verbindungsschaltung (4) verbunden sind, die Ausbreitungsvektoren der Störungen bilden können, und
- andererseits einen Schutzmodul (11), der ein Gehäuse (12) aufweist, das Schutzschaltungen aufnimmt, die den Leitern (L₁, L₂ ... Lₙ) zugeordnet und elektrisch mit Verbindungsorganen (B₁ bis B₉) eines zweiten Verbinderelements (10) verbunden sind, das sich an das erste Verbinderelement (7) anschließen kann, um eine abschaltbare elektrische Verbindung zwischen den Leitern (L₁, L₂ ... Lₙ) und den entsprechenden Schutzschaltungen zu gewährleisten.

2. Vorrichtung nach Anspruch 1, dadurch gekennzeichnet, daß die Leitungen (L₁ bis Lₙ) der Verbindungsschaltung, die die Verbindungen zwischen den modularen Elementen (M₁, M₂, M₃) und den äußeren Schaltungen gewährleisten, so angeordnet sind, daß sie eine Übergangsmatrix (6) bilden, von der jeder Punkt (P₁₁, ... Pₙ₇, P'₁₁ ... P'ₙ₇), der mit einer entsprechenden Leitung (L₁ bis Lₙ) in elektrischem Kontakt steht, mit einem Verbindungsorgan (O₁ ... O₉) des ersten Verbinderelements (7) verbunden ist.

3. Vorrichtung nach Anspruch 2, dadurch gekennzeichnet, daß die Schutzschaltungen mindestens eine Blitzschutz-Diode (D₁, D₂) aufweisen, die zwischen Masse und mindestens einem der Punkte der Übergangsmatrix (6) über die beiden Verbinderelemente (7, 10) verbunden ist.

4. Vorrichtung nach Anspruch 1, dadurch gekennzeichnet, daß mindestens ein Teil der Leitungen (L₁ ... Lₙ) der Verbindungsschaltung (4), die die Verbindungen zwischen den modularen Elementen (M₁, M₂, M₃) und den äußeren Schaltungen gewährleistet, so angeordnet ist, daß er eine Übergangsmatrix (6) bildet, und daß jede der Leitungen (L₁ ... Lₙ) zwischen zwei Punkten unterbrochen ist, die sich in der Übergangsmatrix (6) befinden und mit zwei Verbindungsorganen des ersten Verbinderelements (7) verbunden sind.

5. Vorrichtung nach Anspruch 4, dadurch gekennzeichnet, daß der Schutzmodul (11) Mittel aufweist, die es ermöglichen, mit Hilfe der beiden Verbinderelemente (7, 10) eine elektrische Verbindung zwischen zwei Punkten der gleichen Leitung (L₁ ... Lₙ) zu gewährleisten, mit einer eventuellen Verbindung mit Masse über eine Blitzschutzschaltung.

6. Vorrichtung nach Anspruch 4, dadurch gekennzeichnet, daß der Schutzmodul eine Schutzschaltung aufweist, die zwischen die beiden Punkte (P₁₁, P'₁₁) der gleichen Leitung (L₁) mit Hilfe der beiden Verbinderelemente (7, 10) geschaltet wird.

7. Vorrichtung nach Anspruch 6, dadurch gekennzeichnet, daß die Schutzschaltung eine Impedanz (L₁), die zwischen den beiden Punkten (P₁₁, P'₁₁) angeschlossen ist, und zwei Kondensatoren (CO₁, CO₂) aufweist, die jeden der Punkte mit Masse verbinden.

8. Vorrichtung nach einem der vorhergehenden Ansprüche, dadurch gekennzeichnet, daß der Schutzmodul (11) ein Gehäuse (12) aufweist, dessen vorderer Bereich aus einem Verbinderelement (10) besteht, das mindestens eine Reihe von Verbindungsorganen (B₁ bis B₉) enthält, die in einen isolierenden Träger (13) montiert sind, und daß die Schutzschaltungen und/oder Verbindungsschaltungen von mindestens einer Druckschaltungsplatte (14) getragen werden, die im Gehäuse angeordnet und elektrisch mit den Verbindungsorganen (B₁ bis B₉) verbunden ist.

9. Vorrichtung nach Anspruch 8, dadurch gekennzeichnet, daß das Verbinderelement (10) des Schutzmoduls (11) eine Vielzahl von Reihen von Verbindungsorganen (B₁ bis B₉) aufweist, die je auf eine Vielzahl von isolierenden Trägern (S₁, Sₙ) montiert sind, die übereinander gestapelt sind, und daß das Gehäuse (12) eine Vielzahl von doppelseitigen Druckschaltungsplatten (14) einschließt, von denen jede Seite elektrisch mit einer entsprechenden Reihe von Verbindungsorganen (B₁ bis B₉) verbunden ist.

## Claims

1. A device for the protection of an electronic installation against the interference generated by phenomena affecting the outer environment in which the installation is placed, said installation comprising a rack (1) in which can be engaged modular functional elements (M₁, M₂, M₃) interconnected to one another and with external circuits by means of an interconnecting circuit (4) provided at the back of the rack,
characterized in that it uses:
- on the one hand, a first connector element (7) mounted on said rack (1) and whose connection members (O₁ to O₉) are electrically linked to respective conductors ( L₁, L₂ ... Lₙ) of the interconnecting circuit (4) susceptible of constituting vectors of propagation of said interference, and
- on the other hand, a protective module (11) comprising a case (12) accommodating protective circuits respectively associated with said conductors (L₁, L₂ ...Lₙ) and electrically linked to connection members (B₁ to B₉) of a second connector element (10) susceptible of connecting into the first connector element (7) in order to provide a disconnectable electrical link between said conductors (L₁, L₂, ...Lₙ) and the corresponding protective circuits.

2. The device as claimed in claim 1,
characterized in that the lines (L₁ to Lₙ) of said interconnecting circuit linking said modular elements (M₁, M₂, M₃) and said external circuits are disposed so as to form a transfer matrix (6) of which each of the points (P₁₁...Pₙ₇, P'₁₁...P'ₙ₇), which is in electrical contact with a corresponding line (L₁ to Lₙ), is connected to a connection member (O₁ to O₉) of said first connector element (7).

3. The device as claimed in claim 2,
characterized in that said protective circuits comprise at least one lightning diode (D₁, D₂) connected between the ground and at least one of said points on said transfer matrix (6), via the two connector elements (7, 10).

4. The device as claimed in claim 1,
characterized in that at least part of the lines (L₁ to Lₙ) of said interconnecting circuit (4) linking said modular elements (M₁, M₂, M₃) and said external circuits are disposed so as to form a transfer matrix (6), and in that each of said lines (L₁ to Lₙ) is interrupted between two points situated in said transfer matrix (6) and connected to two connection members of said first connector element (7).

5. The device as claimed in claim 4,
comprises a means enabling, by means of said two connector elements (7, 10), two points of a same line (L₁ to Lₙ) to be electrically connected, with a possible link to the ground via a lightning protection circuit.

6. The device as claimed in claim 4,
characterized in that said protective module comprises a protective circuit connected between the two points (P₁₁, P'₁₁) of a same line (L₁) by means of said two connector elements (7, 10).

7. The device as claimed in claim 6,
characterized in that said protective circuit comprises an impedor (L₁) connected between said points (P₁₁, P'₁₁) and two capacitors (CO₁, CO₂) connecting each of said points to the ground.

8. The device as claimed in one of the preceding claims,
characterized in that said protective module (11) comprises a case (12) whose front part is constituted by a connector element (10) comprising at least one line of connection members (B₁ to B₉) mounted on a line of connection members (B₁ to B₉) mounted on a support insulator (13), and in that the protective and/or connecting circuits are mounted on at least one printed circuit chip (14) accommodated in said case (12) and electrically connected to said connection members (B₁ to B₉).

9. The device as claimed in claim 8,
characterized in that said connector element (10) of said protective module (11) comprises a plurality of lines of connection members (B₁ to B₉) respectively mounted on a plurality of support insulators (S₁, Sₙ) stacked on top of one another, and in that said case (12) contains a plurality of double-sided printed circuit chips (14) of which each side is electrically connected to a corresponding line of connection members (B₁ to B₉).
